(19) Europäisches Patentamt / European Patent Office / Office européen des brevets

(11) **EP 2 533 294 B1**

(12) **EUROPÄISCHE PATENTSCHRIFT**

(45) Veröffentlichungstag und Bekanntmachung des Hinweises auf die Patenterteilung:
**27.07.2016 Patentblatt 2016/30**

(51) Int Cl.:
*H01L 31/02* *(2006.01)* *H01L 31/042* *(2006.01)*
*H02J 1/10* *(2006.01)* *H02J 3/38* *(2006.01)*
*H02M 1/08* *(2006.01)* *H02K 17/16* *(2006.01)*
*H03K 17/0812* *(2006.01)* *H03K 17/16* *(2006.01)*

(21) Anmeldenummer: **12164437.1**

(22) Anmeldetag: **17.04.2012**

(54) **Solarmodul und Verfahren zu dessen Betrieb**

Solar module and method for its operation

Module solaire et son procédé de fonctionnement

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.06.2011 DE 102011077160**

(43) Veröffentlichungstag der Anmeldung:
**12.12.2012 Patentblatt 2012/50**

(73) Patentinhaber: **SEMIKRON Elektronik GmbH & Co. KG**
**90431 Nürnberg (DE)**

(72) Erfinder:
• **Beckedahl, Peter**
  **90522 Oberasbach (DE)**
• **Weiß, Rainer**
  **91052 Erlangen (DE)**
• **Staudt, Ingo**
  **90439 Nürnberg (DE)**

(56) Entgegenhaltungen:
| | |
|---|---|
| EP-A2- 0 730 331 | EP-A2- 1 463 188 |
| WO-A1-2011/048122 | DE-A1- 10 035 387 |
| DE-A1- 10 035 388 | DE-A1-102005 016 440 |
| DE-A1-102009 025 363 | JP-A- H11 234 104 |
| JP-A- 2001 103 791 | KR-A- 20090 096 781 |

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft ein Solarmodul, umfassend eine Solarzelle und einen Stromrichter, und ein Verfahren zu dessen Betrieb.

Zur Erzeugung regenerativer Energie werden Solarzellen eingesetzt. Um die von den Solarzellen erzeugte Gleichspannung z.B. für ein Energieversorgungsnetz aufzubereiten, werden diese in einem Solarmodul mit einem Stromrichter, i.d.R. einem Wechselrichter, kombiniert. Der Stromrichter richtet die von der Solarzellen in den Stromrichter eingespeiste Gleichspannung in eine dem Energieversorgungsnetz zuzuführende Wechselspannung um. Die hier in der Regel in der Einzahl angesprochene Solarzelle besteht in der Praxis oft aus einer Mehrzahl von in Reihe geschalteten einzelnen Solarzellen. Der Stromrichter weist in einer bekannten, einfachen Ausführungsform mindestens zwei Transistorhalbbrücken auf. Jede Halbbrücke enthält dabei dann mindestens zwei Transistoren mit mindestens zwei Freilaufdioden. Weitere Halbleiter können zwischen Solarzelle und Stromrichter liegen. Die von der Solarzelle erzeugte Gleichspannung wird also i.d.R. mittels eines Wechselrichters in das Wechselstromnetz gespeist. Dazu wird ein Pulsmuster erzeugt, mit dem die Transistoren des Wechselrichters geschaltet werden.

Unbeleuchtete oder schwach beleuchtete Solarzellen liefern keine oder eine zu geringe Gleichspannung, um diese vom Stromrichter weiterverarbeiten zu lassen. Der Stromrichter ist daher zunächst außer Betrieb. Bei Beginn einer Bestrahlung der Solarzelle steigt deren Leerlaufspannung schnell und auf einen im Vergleich zum Normalbetrieb hohen Wert an. Die Leerlaufspannung liegt an, wenn kein oder nur sehr geringer Laststrom durch die Solarzelle fließt. Gegenüber einer Ausgangsspannung bei Belastung der Solarzelle mit einem Laststrom ist dieser Wert sehr hoch, häufig etwa doppelt so hoch. Dies liegt am Innenwiderstand der Solarzellen.

Insbesondere bei kalten Umgebungstemperaturen, das heißt im Winter und bei Sonnenaufgang weist die Solarzelle eine maximale Leerlaufspannung auf. Folglich erreicht auch die am Wechselrichter anstehende Gleichspannung in Form von dessen Zwischenkreisspannung ein Maximum, da der Wechselrichter noch nicht in Betrieb ist und daher kein nennenswerter Strom durch die Solarzelle fließt. Im Betrieb des Wechselrichters, d.h. wenn der Solarzelle Laststrom entzogen wird, bricht die Gleichspannung wesentlich ein, zum Beispiel von einer Spitzenspannung von 900V auf eine reguläre (Betriebs-)Spannung von 500V. Die von der Solarzelle abgegebene Spannung hängt also u.a. von der Sonneneinstrahlung, der Temperatur und dem Stromfluss durch die Zelle ab.

So ist immer wieder ein Anlauf- bzw. Übergangsbetrieb denkbar, in dem die Ausgangsspannung der Solarzelle über der erlaubten Eingangsspannung des Stromrichters liegt.

Es ist bekannt, einen Wechselrichter für die Solarzelle zu verwenden, der lediglich für die Betriebsspannung der Solarzelle, im Beispiel für 500V, ausgelegt ist. Im oben geschilderten Anlauffall wird jedoch dann die zulässige Betriebsspannung des Wechselrichters durch die Leerlaufspannung der Solarzelle von 900V deutlich überschritten. Ein direkter Anlauf ist also hier wegen der Spannungsüberschreitung nicht zulässig.

Bekannt ist es, in einem Anlaufbetrieb der Solarzelle dem Eingang des Wechselrichters eine Einrichtung zur temporären Reduktion der Zwischenkreisspannung, einen -Chopper zuzuordnen, z.B. mit einen Lastwiderstand. Vor Anschalten des Wechselrichters wird die Solarzelle durch den Chopper belastet. Es fließt ein Laststrom in der Solarzelle. Der hierbei durch den chopper fließende Strom belastet die Solarzelle, so dass deren Spannungswert und somit die dem Stromrichter zuzuführende Zwischenkreisspannung auf einen Wert sinkt, der sich im erlaubten Spannungsbereich des Wechselrichters befindet. Die Eingangsspannung, das heißt die Zwischenkreisspannung des Stromrichters, wird daher auf die maximal zulässige Zwischenkreisspannung reduziert. Hierauf kann der Wechselrichter in Betrieb gesetzt werden, der Chopper wird inaktiv, der Wechselrichter kann anlaufen und Leistung ins Netz speisen. Im Anlaufbetrieb der Solarzelle ist also bei einer derartigen Konfiguration ein chopper erforderlich.

Alternativ ist es bekannt, in einem Solarmodul weniger Solarzellen zu verwenden, um dessen Maximalspannung abzusenken bzw. den Stromrichter auf die maximal verfügbare Leerlaufspannung der Solarzellen zu dimensionieren. Die Spannung am Stromrichter wird durch die Anzahl der aneinandergereihten Solarzellen bestimmt. Dabei wird eine möglichst große Spannung angestrebt, da dann mit einem Wechselrichter die meiste Energie übertragen werden kann. Auch in einem Anlaufbeziehungsweise Übergangsbetrieb ist dann die maximale Leerlaufspannung, das heißt die dem Stromrichter maximal zugeführte Spannung stets unterhalb der zulässigen Stromrichterspannung beziehungsweise Zwischenkreisspannung. Da der Übergangsbetrieb nur wenige Sekunden im Vergleich zu vielen Stunden Normalbetrieb dauert, arbeitet jedoch im Normalbetrieb der Stromrichter nun deutlich unterhalb seiner Dimensionierungsgrenzen. Die Halbleiter im Stromrichter werden nur wenige Sekunden spannungsmäßig voll ausgelastet, in der restlichen Zeit ist der Stromrichter überdimensioniert. Sobald der Stromrichter zum Netz hin arbeitet, sinkt die Spannung, wie oben beschrieben, deutlich ab.

Aus der JP 2001103791 A ist ein Solarmodul mit einer Solarzelle und einem Wechselrichter, der den Motor einer Pumpe antreibt, bekannt, wobei die Solarzelle mittels eines Transistors solange elektrisch kurzgeschlossen wird bis der durch die Solarzelle fließende Kurzschlussstrom einen Grenzwert überschreitet. Wenn der Kurzschlussstrom den Grenzwert überschreitet wird der Transistor ausgeschaltet und der Wechselrichter erzeugt einen niederfrequenten Wechselstrom zur Stromversorgung des Motors für die Pumpe. In Abhängigkeit von der Höhe der elektrischen Spannung, die von der Solarzelle erzeugt wird, wird die Frequenz des Wechselstroms, die vom Wechselrichter erzeugt wird, verändert, wobei mit steigender elektrischer Spannung der Solarzelle die Frequenz des Wechselstroms vom Wechselrichter erhöht wird um das Drehmoment des Motors zu erhöhen.

Aus der KR 1020090096781 A ist ein Solarmodul mit einer Solarzelle und einem Wechselrichter bekannt, wobei die von der Solarzelle erzeugte Spannung überwacht wird. Wenn die von der Solarzelle erzeugte Spannung einen Grenzwert überschreitet wird der Wechselrichter in Betrieb genommen.

Aus der JP 11234104 A ist eine Leistungshalbleitereinrichtung mit einem Leistungshalbleiterschalter bekannt, bei der der durch den Leistungshalbleiterschalter fließende Strom ermittelt wird und in Abhängigkeit der Höhe des Stroms das Schaltverhalten des Leistungshalbleiterschalters derart angepasst wird, dass ein hoher Strom langsam vom Leistungshalbleiterschalter ausgeschaltet wird.

Aufgabe der Erfindung ist es, ein verbessertes Solarmodul beziehungsweise ein verbessertes Verfahren zu dessen Betreiben anzugeben.

Hinsichtlich des Solarmoduls wird die Aufgabe gelöst gemäß Patentanspruch 1. Das Solarmodul enthält eine, eine Gleichspannung erzeugende, Solarzelle. Die Solarzelle ist mit einem Stromrichter verbunden, beziehungsweise speist diesen an dessen Eingang mit der von ihr erzeugten Gleichspannung. Der Stromrichter richtet die Gleichspannung zum Beispiel in eine Netzwechselspannung eines Versorgungsnetzes um. Der Stromrichter enthält mindestens einen Halbleiterschalter und eine, einen Schalteingang des Halbleiterschalters ansteuernde Steuerung. Erfindungsgemäß ist die Steuerung derart ausgebildet: In einem Übergangsbetrieb des Solarmoduls wird der Halbleiterschalter im Gegensatz zum Normalbetrieb derart verändert angesteuert, dass dieser ein gegenüber dem Normalbetrieb langsameres Schaltverhalten aufweist. Das Schaltverhalten ist derart langsamer, dass eine dynamische Überspannung am Halbleiterschalter reduziert wird. Die Überspannung wird derart reduziert, dass die am Halbleiterschalter anliegende Spannung die Sperrspannung des Halbleiterschalters nicht überschreitet.

Die Erfindung eignet sich für alle Arten von ein- und mehrphasigen Stromrichtern mit allen Arten von Halbleiterschaltern bevorzugt Transistoren. Ein bevorzugter Stromrichter weist mehrere, zum Beispiel vier Halbleiterschalter auf, welche in H-Brückenschaltung verschaltet sind. Andere bekannt Topologien sind Multilevelstromrichter, beispielhaft Drei-Level-Wechselrichter.

Die Erfindung beruht auf folgenden Erkenntnissen bzw. Überlegungen:

In einem Wechselrichter mit einer Halbbrücke kommutiert ein Strom vom oberen Transistor, dem oberen Halbleiterschalter einer Halbbrücke, auf die jeweilige untere Freilaufdiode des dortigen Halbleiterschalters und zurück bzw. vom unteren Transistor der Halbbrücke auf die obere Freilaufdiode. Wegen parasitärer Induktivitäten der Halbbrücke und/oder der Anschlüsse zum Zwischenkreiskondensator entsteht dabei eine dynamische Überspannung an den Halbleitern, die von der Stromsteilheit bei der Kommutierung abhängt. Die dynamische Überspannung wird erzeugt durch parasitäre Induktivitäten. Die dynamische Überspannung überlagert sich der Spannung am Kondensator, welche im Wesentlichen von der Solarzelle vorgegeben wird. Beim Schalten ist daher die Halbleiterspannung die Summe aus Kondensatorspannung und dynamischer Überspannung. Diese Spannung am Halbleiter darf niemals dessen spezifizierte Spannung überschreiten, da dieser ansonsten beschädigt oder zerstört wird.

Die Stromsteilheit bei der Kommutierung wird vom Aufbau des Wechselrichters und dessen Komponenten, insbesondere von den parasitären Induktivitäten, speziell den Aufbau- und Verbindungskomponenten des Zwischenkreises, und von den Schalteigenschaften der Transistoren bestimmt. Mit der Beschaltung des Schalteingangs des Transistors, also z.B. der Basisbeschaltung, kann dessen Schaltverhalten verändert werden. Die Ansteuerung des Schalteingangs erfolgt dazu in der Regel durch eine Spannungsquelle, welche über einen Widerstand mit dem Steuereingang verbunden ist, z.B. also einen Basiswiderstand oder Gate-Widerstand. Einfluss auf das Schaltverhalten kann durch Variation des Widerstandswertes oder auch des Spannungswertes der Spannungsquelle genommen werden. Ein vergrößerter Widerstand oder eine kleinere Steuerspannung reduziert hierbei die Stromsteilheit bei der Kommutierung des Halbleiterschalters und erzeugt somit weniger dynamische Überspannungen beim Schalten an diesem. Andererseits entstehen dann hohe Schaltverluste im Halbleiterschalter, was vor allem bei großem Laststrom von Nachteil ist. Bei kleinen Lastströmen hat dies jedoch kaum Bedeutung.

Ein verkleinerter Widerstand und/oder eine betragsmäßige vergrößerte Steuerspannung erhöht dagegen die Stromsteilheit bei der Kommutierung und erzeugt somit eine große dynamische Überspannung am Halbleiterschalter. Andererseits sind dann jedoch die Schaltverluste gering. Das Abschalten des jeweiligen Halbleiterschalters wird mit negativer Spannung durchgeführt. Hier wird beispielhaft nur das Einschalten betrachtet, aber bei Ausschalten funktioniert das Verfahren analog.

Denkbar ist es zunächst, den Stromrichter bei einer Eingangsspannung zu starten, welche dessen zulässige Dauereingangsspannung beziehungsweise Zwischenkreisspannung bei Normalbetrieb übersteigt: Hier wird der Wechselrichter zunächst mit sehr geringem Ausgangsstrom in Betrieb gesetzt, um die Solarzelle zumindest geringfügig durch Stromfluss zu belasten.

Bereits dadurch sinkt die Spannung der Solarzelle - ausgehend von der Leerlaufspannung - deutlich ab. Durch die sich allmählich reduzierende Zwischenkreisspannung bei jeweils erhöhtem Laststrom kann der Ausgangsstrom des Wechselrichters bis zum Nominalwert erhöht werden. In diesem Übergangsbetrieb mit erhöhter Zwischenkreisspannung muss die dynamische Überspannung kleiner sein als im Normalbetrieb, damit die Gesamtspannung aus Zwischenkreisspannung, also Spannung der Solarzelle plus dynamische Überspannung, stets kleiner ist als die Sperrspannung der Halbleiterschalter. Die Sperrspannung ist hierbei die Maximalspannung des Leistungs- also Halbleiterschalters.

Die Spannung U am Halbleiterschalter rührt aus der Spannung der Solarzelle, bzw. Zwischenkreisspannung gleichen Werts, und der durch dynamische Effekte erzeugten dynamischen Überspannung. Entscheidend für die dynamische Überspannung sind die durch parasitäre Induktivitäten L fließenden Ströme I, bzw. deren zeitliche Änderung, die zu einer induzierten Spannung, der dynamischen Überspannung $U_{Ü}$, führt. Die Spannungen U ergeben sich gemäß $U = L dI/dt$, also proportional zu einer zeitlichen Änderung des Stromes I. Durch den erfindungsgemäßen Betrieb der Steuerung erfolgt ein langsameres Schalten der Leistungshalbleiter und damit eine langsamere Stromänderung. Die dynamischen Überspannungen im Stromrichter sinken deutlich. Zwar arbeitet in diesem Übergangsbetrieb der Stromrichter nicht optimal bezüglich seiner dynamischen Verluste. Dies wird gemäß der Erfindung jedoch für den zum Normalbetrieb nur sehr kurzzeitig erfolgenden Übergangsbetrieb bewusst toleriert. Die Dimensionierungsgrenzen des Stromrichters können dann dennoch auf die Solarspannungen im Normalbetrieb ausgerichtet werden. Erfindungsgemäß werden also die besonderen Eigenschaften einer Kombination aus Solarzelle und Stromrichter genutzt, da die extrem überhöhte Leerlaufspannung der Solarzelle besonders schnell bei auch nur geringen Belastungsströmen der Solarzelle einbricht und somit der Übergangsbetrieb nur von besonders kurzer Dauer ist.

Halbleiterschalter reagieren besonders kritisch auf überhöhte Spannung. Einmaliges Überschreiten der Sperrspannung kann einen Leistungshalbleiter bereits zerstören. Durch die Erfindung werden Überspannungen vermieden. Dagegen werden hier hohe thermische Verluste während des Übergangsbetriebs im Stromrichter hingenommen. Die thermische Belastung steigt jedoch im Sinne einer Zeitmittelung erst langsam im Stromrichter an. Da in der Regel die Zeitdauer des Übergangsbetriebes kürzer ist, als dass der thermische Anstieg schädlich werden könnte, kann das thermische Verhalten des Stromrichters hier abgepuffert werden. Die Zeitdauer des Übergangsbetriebes, in welcher die (eigentlich zu hohe) Verlustleistung anfällt, reicht in der Regel also nicht aus, um diesen thermisch zu überlasten. Im Normalbetrieb, das heißt mit regulärem, auf thermische Belastung optimiertem Schaltverhalten sinkt die thermische Augenblicksbelastung im Stromrichter wieder auf das erlaubte Niveau ab.

Die parasitären Induktivitäten sind immer vorhanden und führen stets zu dynamischer Überspannung. Im Normalbetrieb weist diese dynamische Überspannung - aufgrund der Optimierung des Schaltverhaltens des Stromrichters auf niedrige Durchgangsverluste - einen gewissen Maximalwert auf, der zusammen mit der Solarspannung unterhalb der Sperrspannung liegen muss. Hierfür ist der Stromrichter ausgelegt. Gemäß der Erfindung wird die dynamische Überspannung im Übergangsbetrieb wesentlich kleiner gehalten als im Normalbetrieb, um die höhere von der Solarzelle gelieferte Spannung zu kompensieren. Es gelten folgende Größen: $U_{PV}$ ist die Spannung der Solarzelle und gleich der Zwischenkreisspannung. $U_{Ü}$ ist die dynamische Überspannung im Übergangsbetrieb. $U_{SP}$ ist die maximal erlaubte Sperrspannung am Halbleiterschalter. Die Erfindung zeigt sich damit im Übergangsbetrieb: In diesem Fall ist die dynamische Überspannung geringer als im Normalbetrieb und muss dabei die folgende Bedingung erfüllen:

$$U_{PV} + U_{Ü} < U_{Sp}$$

Mit anderen Worten findet also bei einem Solarstromrichter bzw. Wechselrichter eine Adaption der Eingangsbeschaltung des Halbleiterschalters, z.B. von dessen Basisbeschaltung, an den Betriebspunkt der Solarzelle statt. Bei großer Sonneneinstrahlung wird viel elektrische Energie erzeugt und der Laststrom steigt an, wobei gleichzeitig die Solarzellenspannung auf Grund des Innenwiderstandes absinkt. Die Schaltverluste der Halbleiter werden mit einem schnellen Schaltverhalten minimiert, der Wirkungsgrad des Wechselrichters steigt. Zum Anlauf der Solarzelle werden dagegen durch ein langsames Schaltverhalten die dynamischen Überspannungen im Stromrichter derart weit abgesenkt, dass diese zusammen mit der erhöhten Ausgangsspannung der Solarzelle noch unterhalb der im Stromrichter erlaubten Spannungsgrenzen liegen. Die erfindungsgemäße Anpassung des Schaltverhaltens kann sowohl nur für das Ein- als auch nur für das Ausschalten oder für das Ein- und Ausschalten der Halbleiterschalter angewendet werden.

In einer bevorzugten Ausführungsform der Erfindung weist der Stromrichter an seinem Eingang eine maximal zulässige Dauerspannung für den Normalbetrieb auf, die kleiner ist als eine im Übergangsbetrieb maximal von der Solarzelle erzeugte Gleichspannung. Mit anderen Worten ist es möglich, dank der Erfindung den Stromrichter lediglich auf die im Normalbetrieb von der Solarzelle erzeugte Betriebsspannung als maximal zulässige Dauerspannung auszulegen und die überhöhte Leerlaufspannung beziehungsweise Anlaufspannung der Solarzelle im Übergangsbetrieb zu tolerieren.

In einer weiteren bevorzugten Ausführungsform wird als Übergangsbetrieb für die Dimensionierung des Stromrichters ein Anlaufbetrieb der Solarzelle gewählt. Im ungünstigsten Fall ist in diesem Anlaufbetrieb die Ausgangsspannung gegenüber dem Normalbetrieb deutlich erhöht. So kann das Solarmodul optimal auch für ungünstigste Betriebsbedingungen der Solarzelle bezüglich Erhöhung ihrer Leerlaufspannung gegenüber der Normalspannung ausgelegt werden.

In einer bevorzugten Ausführungsform der Erfindung enthält die Steuerung eine den Halbleiterschalter ansteuernde Spannungsquelle. Erfindungsgemäß ist dann der Wert der dem Schalteingang von der Spannungsquelle zugeführten Spannung veränderbar. Mit anderen Worten wird die Eingangs- bzw. Steuerspannung des Halbleiterschalters, also z.B. die Basisspannung des Transistors, an die Spannung am Kondensator bzw. die Ausgangsspannung der Solarzelle angepasst, und zwar derart, dass bei großer Kondensatorspannung die Steuerspannung klein und bei fallender Kondensatorspannung die Steuerspannung vergrößert wird. Die Anpassung der Spannung kann beispielsweise durch eine Veränderung des wirksamen Innenwiderstands der Spannungsquelle erreicht werden. Dazu wird entweder ein Spannungsabfall in Reihe zur Quelle erzeugt, z.B. mit einem weiteren Transistor, oder die Spannungsquelle wird im Pulsbetrieb nach Art einer PWM-Schaltung betrieben, um die effektive, am Schalteingang anliegende, am Halbleiterschalter wirkende Spannung zu verändern. Auch kann einfach die Spannung der Spannungsquelle an sich abgesenkt werden.

In einer weiteren Ausführungsform enthält das Solarmodul bzw. in der Regel die Steuerung einen zum Schalteingang des Halbleiterschalters führenden elektrischen Widerstand. Die Ansteuerung des Halbleiterschalters erfolgt also über diesen Widerstand. Dessen Widerstandswert ist dann veränderbar, um das o.g. Schaltverhalten zu erreichen.

In einem Übergangsbetrieb des Stromrichters ist der Widerstandswert des Widerstandes gegenüber dessen Widerstandswert in einem Normalbetrieb des Stromrichters vergrößerbar. Mit anderen Worten wird im Übergangsbetrieb der Widerstandswert des Widerstandes gegenüber dessen Widerstandswert im Normalbetrieb vergrößert bzw. erhöht.

Der Halbleiterschalter ist in der Regel ein Bipolartransistor oder IGBT (insulated gate bipolar transistor), dessen Schalteingang hat dann eine Basis oder ein Gate. Der Widerstand ist dann ein Basis- oder Gate-Widerstand. Der Widerstand ist beispielsweise ein separates Bauteil oder dieser ist in die Steuerung, in der Regel also einen Treiber, integriert. Der Widerstand kann aber auch als Vorwiderstand des Halbleiterschalters zusammen mit diesem in ein Halbleitermodul integriert sein.

Das Schaltverhalten der Leistungshalbleiter im Stromrichter wird auch durch deren Vorwiderstände bestimmt, über welche deren Steuereingänge (z.B. das Gate eines IGBT) mit einer Steuerung, z.B. mit einem Treiber, verbunden sind. Die Vorwiderstände, in der Regel dann Gatewiderstände, sind hierbei auf minimale Verluste des Wechselrichters optimiert, was jedoch hohe dynamische Überspannungen innerhalb des Wechselrichters an den Leistungshalbleitern zur Folge hat. Diese Überspannungen stellen bei der maximal zulässigen Spannung des Wechselrichters, also der nominalen Zwischenkreisspannung, keine Gefahr dar. Da jedoch in der beschriebenen Art und Weise der Wechselrichter bei einer überhöhten Spannung anlaufen soll, besteht die Gefahr der Zerstörung der Halbleiter wegen Überschreiten der Sperrspannung. Die Erfindung verhindert dies wie oben erläutert.

Die Ausführungsformen der Veränderung der Spannungsquelle und der Widerstände können jeweils alleine oder in Kombination genutzt werden.

In einer weiteren bevorzugten Ausführungsform ist der Widerstand ein zwischen mindestens zwei Widerstandswerten umschaltbarer Widerstand. Eine Verwendung von nur zwei verschiedenen Widerstandswerten reicht für die Umsetzung des erfinderischen Gedankens im Solarmodul aus. Derartige umschaltbare Widerstände können besonders einfach realisiert werden. In einem Normalbetrieb weist der Widerstand dann einen ersten, im Übergangsbetrieb einen größeren zweiten Wert auf.

In einer besonders einfachen Ausführungsform enthält der Widerstand zwischen seinen beiden Anschlüssen mindestens zwei, zwischen die Anschlüsse wahlweise einschaltbare Teilwiderstände. Hierbei ist beispielsweise eine Lösung einer tatsächlichen alternativen Umschaltung zwischen erstem und zweitem Widerstand denkbar. Denkbar ist aber auch eine zur Absenkung des Widerstandswertes parallele Zuschaltung eines ersten Teilwiderstandes während des Normalbetriebes zu einem im Umschaltbetrieb einzig verwendeten zweiten Teilwiderstand; alternativ auch eine entsprechende Reihenschaltung mit Bypassfunktion für einen der Teilwiderstände.

In einer weiteren bevorzugten Ausführungsform enthält das Solarmodul ein Wächtermodul, welches derart ausgebildet ist, dass es den Stromrichter bezüglich einer Überhitzung überwacht. Da im Übergangsbetrieb die Gefahr einer thermischen Überlastung des Stromrichters in Kauf genommen wird, falls der Übergangsbetrieb länger als beabsichtigt dauert, ist eine thermische Überwachung des Solarmoduls an dieser Stelle besonders sinnvoll, um hier beispielsweise eine Notabschaltung, das heißt eine Spannungsfreischaltung des Stromrichters, zu erreichen, um diesem Gelegenheit zur Abkühlung zu geben.

In einer weiteren bevorzugten Ausführungsform erhält das Solarmodul ein Wächtermodul, das derart ausgebildet ist, dass es eine Betriebsdauer des Übergangsbetriebes überwacht. Auch dies dient, wie oben beschrieben, einer Absicherung der thermischen Überlastung des Stromrichters im Übergangsbetrieb, hier jedoch nicht nur durch eine Temperatur-, sondern durch eine indirekte Zeitüberwachung der Dauer des Übergangsbetriebes und damit einer Abschätzung der hierbei entstehenden thermischen Belastung im Stromrichter. Auch hier kann eine Notabschaltung durch das Wächtermodul erfolgen.

Hinsichtlich des Verfahrens wird die Aufgabe gelöst durch ein Verfahren gemäß Patentanspruch 8 zum Betreiben eines wie oben beschriebenen Solarmoduls. Wie bereits erwähnt, wird erfindungsgemäß im Übergangsbetrieb des Stromrichters durch die Steuerung ein langsameres Schaltverhalten der Halbleiterschalter bewirkt.

Das Verfahren zusammen mit seinen Vorteilen und bevorzugten Ausführungsformen wurde bereits oben im Zusammenhang mit dem erfindungsgemäßen Solarmodul erläutert.

Für eine weitere Beschreibung der Erfindung wird auf die Ausführungsbeispiele der Zeichnung verwiesen.

Es zeigen, jeweils in einer schematischen Prinzipskizze:

Fig. 1　　ein erfindungsgemäßes Solarmodul,
Fig. 2　　einen alternativen elektrischen Widerstand.

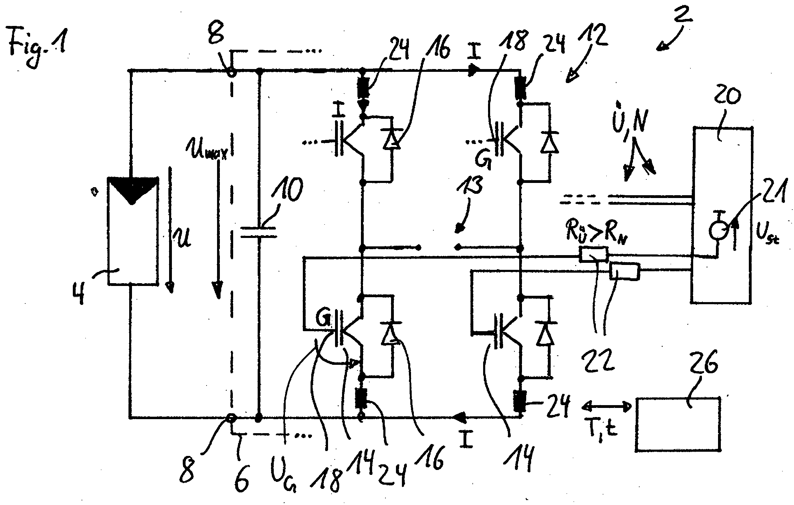

Fig. 1 zeigt ein Solarmodul 2, umfassend eine Solarzelle 4 und einen Stromrichter 6. Die Solarzelle 4 erzeugt im Betrieb eine Gleichspannung U, die sie in einen Eingang 8 des Stromrichters 6 einspeist. Der Stromrichter 6 richtet die Gleichspannung U in nicht näher bezeichnete Spannung, beispielsweise eine Netzspannung um.

Der Stromrichter 6 enthält einen Zwischenkreiskondensator 10, sowie eine H-Brücke 12 mit vier Halbleiterschaltern 14 in Form von IGBTs, denen jeweilige Dioden 16 antiparallel geschaltet sind. Jeder der Halbleiterschalter 14 weist einen Schalteingang 18 auf, hier jeweils das Gate G des IGBTs. Der Stromrichter 6 besitzt in der H-Brücke 12 einen Ausgang zu einem Netz 13.

Der Stromrichter 6 enthält außerdem eine Steuerung 20, , welche die jeweiligen Schalteingänge 18 der Halbleiterschalter 14 ansteuert. Jeder Schalteingang 18 ist über einen Widerstand 22 mit der Steuerung 20 verbunden. In der Steuerung befindet sich wiederum eine mit den Widerständen verbundene Spannungsquelle 21 mit einer Steuerspannung $U_{St}$. Am Schalteingang 18 ergibt sich dann eine dem Halbleiterschalter 14 zugeführte Schaltspannung $U_G$. Erfindungsgemäß ist der Widerstand 22 so ausgeführt, dass dieser in einem Normalbetrieb einen ersten Widerstandswert $R_N$ aufweist. In einem Übergangsbetrieb des Stromrichters 6 allerdings weist der Widerstand 22 einen Widerstandswert $R_Ü$ auf, welcher größer als der Widerstandswert $R_N$ ist. Der Stromrichter 6 weist an seinem Eingang 8 eine maximal für einen Normalbetrieb zulässige Höchstspannung $U_{max}$ auf. Dies ist die (Maximal-)Spannung im Dauerbetrieb am Ausgang der Solarzelle.

Der Übergangsbetrieb des Stromrichters 6 erfolgt stets dann, wenn die Gleichspannung U größer der Höchstspannung $U_{max}$ ist. Symbolisch sind im Solarmodul 2 einige wenige parasitäre Induktivitäten 24 angedeutet. Wird bei einer Gleichspannung U, die höher ist als die Höchstspannung $U_{max}$ der Stromrichter 6 mit dem Widerstandswert $R_N$ betrieben, entstehen an den parasitären Induktivitäten 24 durch die sich schnell ändernden Ströme I im Stromrichter 6, verursacht durch das schnelle Schalten der Halbleiterschalter 14, dynamische Spannungen an den parasitären Induktivität 24, welche eine Zerstörung der Halbleiterschalter 14 bewirken.

Da erfindungsgemäß in diesem Übergangsbetrieb jedoch der höhere Widerstandswert $R_Ü$ verwendet wird, werden die Halbleiterschalter 14 ein langsameres Schaltverhalten gegenüber dem Normalbetrieb zeigen. Die zeitlichen Änderungen der Ströme I im Stromrichter 6 sind geringer und damit sind die induzierten Spannungen an den Induktivitäten 24 ebenfalls geringer, so dass die zulässigen Höchstspannungen an den Halbleiterschaltern 14 nicht überschritten werden.

In einer alternativen Ausführungsform wird alternativ oder zusätzlich zur Veränderung des Widerstandswertes des Widerstandes 22 die dem Halbleiterschalter 14 zugeführte Schaltspannung $U_G$ in ihrem Wert verändert. Hierzu wird dann die Steuerspannung $U_{St}$ verändert, z.B. durch Erhöhung eines Innenwiderstandes in der Spannungsquelle 21. Im Übergangsbetrieb Ü werden so die Werte beider Spannungen gegenüber den Werten im Normalbetrieb N abgesenkt.

Der Stromrichter 6 enthält außerdem ein Wächtermodul 26, welches zumindest während des Übergangsbetriebes Ü entweder eine Temperatur T oder eine Zeit t als Dauer des Übergangsbetriebes Ü überwacht, um eine thermische Überlastung des Stromrichters 6 beziehungsweise dessen Halbleiterschaltern 14 zu verhindern und diesen notfalls abzuschalten.

Im Übergangsbetrieb Ü entstehen daher zwar höhere Schaltverluste in den Halbleiterschaltern 14. Diese werden erfindungsgemäß, wegen der geringen Zeitdauer des Übergangsbetriebes Ü im Vergleich zum Normalbetrieb N toleriert.

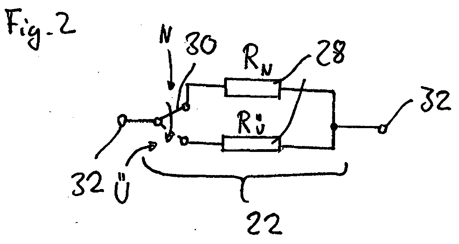

Fig. 2 zeigt eine Ausführungsform eines Widerstandes 22, welcher zwischen zwei Widerstandswerten $R_N$ und $R_Ü$ umschaltbar ist. Der Widerstand 22 enthält zwei Teilwiderstände 28, von welchen einer den Widerstandswert $R_N$ und der andere den Widerstandswert $R_Ü$ aufweist. Durch einen Schalter 30 sind diese wahlweise, je nach Normalbetrieb N oder Übergangsbetrieb Ü, zwischen die beiden Anschlüsse 32 des Widerstandes 22 schaltbar.

**Patentansprüche**

1.　Solarmodul (2) mit einer eine Gleichspannung (U) erzeugenden Solarzelle (4), und mit einem die in seinen Eingang (8) eingespeiste Gleichspannung (U) wandelnden Stromrichter (6), der mindestens einen Halbleiterschalter (14) und eine einen Schalteingang (18) des Halbleiterschalters (14) ansteuernde Steuerung (20) enthält, bei dem die Steuerung (20) derart ausgebildet ist, dass sie in einem Übergangsbetrieb (Ü) des Solarmoduls (2) mindestens einen der Halbleiterschalter (14) derart verändert ansteuert, dass dieser ein gegenüber einem Normalbetrieb (N) derart langsameres Schaltverhalten zeigt, dass eine dynamische Überspannung am Halbleiterschalter (14) derart reduziert wird, dass die am Halbleiterschalter (14) anliegende Spannung die Sperrspannung des Halbleiterschalters (14) nicht überschreitet, wobei durch das langsamere Schaltverhalten die zeitlichen Änderungen der Ströme (I) im Stromrichter (6) geringer sind als im Normalbetrieb (N), wobei der Übergangsbetrieb (Ü) stets dann erfolgt, wenn die Gleichspannung (U) größer als eine Höchstspannung ($U_{max}$) ist.

2.  Solarmodul (2) nach Anspruch 1, wobei die Steuerung (20) eine den Halbleiterschalter (14) ansteuernde Spannungsquelle (21) enthält, bei dem der Wert der dem Schalteingang (18) zugeführten Schaltspannung ($U_G$) veränderbar ist.

3.  Solarmodul (2) nach einem der vorhergehenden Ansprüche, wobei die Steuerung (20) einen zum Schalteingang (18) führenden elektrischen Widerstand (22) aufweist, bei dem der Widerstandswert ($R_{Ü,N}$) des Widerstandes (22) veränderbar ist.

4.  Solarmodul (2) nach Anspruch 3, bei dem der Widerstand (22) ein zwischen mindestens zwei Widerstandswerten ($R_N$,$R_Ü$) umschaltbarer Widerstand ist.

5.  Solarmodul (2) nach Anspruch 4, bei dem der Widerstand (22) zwischen seinen beiden Anschlüssen (32) mindestens zwei wahlweise einschaltbare Teilwiderstände (28) enthält.

6.  Solarmodul (2) nach einem der vorhergehenden Ansprüche, mit einem eine Überhitzung des Stromrichters (6) überwachenden Wächtermodul (26).

7.  Solarmodul (2) nach einem der vorhergehenden Ansprüche, mit einem eine Betriebsdauer (t) des Übergangsbetriebes (Ü) überwachenden Wächtermodul.

8.  Verfahren zum Betreiben eines Solarmoduls (2) gemäß einem der Ansprüche 1 bis 7, bei dem die Steuerung (20) in einem Übergangsbetrieb (Ü) des Solarmoduls (2) den Halbleiterschalter (14) derart verändert ansteuert, dass dieser ein gegenüber einem Normalbetrieb (N) derart langsameres Schaltverhalten zeigt, dass eine dynamische Überspannung am Halbleiterschalter (14) derart reduziert wird, dass die am Halbleiterschalter (14) anliegende Spannung die Sperrspannung des Halbleiterschalters (14) nicht überschreitet, wobei durch das langsamere Schaltverhalten die zeitlichen Änderungen der Ströme (I) im Stromrichter (6) geringer sind als im Normalbetrieb (N), wobei der Übergangsbetrieb (Ü) stets dann erfolgt, wenn die Gleichspannung (U) größer als eine Höchstspannung ($U_{max}$) ist.

9.  Verfahren nach Anspruch 8, bei dem der Wert ($U_{Ü,N}$) der dem Schalteingang (18) zugeführten Spannung ($U_G$) verändert wird.

10. Verfahren nach Anspruch 8 oder 9, bei dem der Widerstandswert ($R_{Ü,N}$) des zum Schalteingang (18) führenden elektrischen Widerstandes (22) verändert wird.

11. Verfahren nach Anspruch 10, bei dem zwischen mindestens zwei Widerstandswerten ($R_N$,$R_Ü$) des Widerstandes (22) umgeschaltet wird.

12. Verfahren nach Anspruch 11, bei dem zwischen beiden Anschlüssen (32) des Widerstandes (22) mindestens zwei Teilwiderstände (28) wahlweise eingeschaltet werden.

13. Verfahren nach einem der Ansprüche 8 bis 12, bei dem das Wächtermodul (26) eine Überhitzung des Stromrichters (6) überwacht.

14. Verfahren nach einem der Ansprüche 8 bis 13, bei dem das Wächtermodul (26) die Betriebsdauer (t) des Übergangsbetriebes (Ü) überwacht.

**Claims**

1.  Solar module (2) having a solar cell (4) generating a DC voltage (U) and having a converter (6) converting the DC voltage (U) fed into its input (8), which contains at least one semiconductor switch (14) and a controller (20) driving a switching input (18) of the semiconductor switch (14), in which the controller (20) is designed in such a way that, in a transition operation (Ü) of the solar module (2), it drives at least one of the semiconductor switches (14) variably in such a way that the latter exhibits a switching behaviour which is slower as compared with normal operation (N), such that a dynamic overvoltage on the semiconductor switch (14) is reduced such that the voltage present on the semiconductor switch (14) does not exceed the blocking voltage of the semiconductor switch (14), wherein, as a result of the slower switching behaviour, the changes over time in the currents (I) in the converter (6) are lower than in normal operation (N), wherein the transition operation (Ü) is then always carried out when the DC voltage (U) is greater than a maximum voltage ($U_{max}$).

2.  Solar module (2) according to Claim 1, the controller (20) containing a voltage source (21) driving the semiconductor switch (14), in which the value of the switching voltage ($U_G$) fed to the switching input (18) can be varied.

3. Solar module (2) according to one of the preceding claims, the controller (20) having an electrical resistor (22) leading to the switching input (18), in which the resistance value ($R_{Ü,N}$) of the resistor (22) can be varied.

4. Solar module (2) according to Claim 3, in which the resistor (22) is a resistor that can be switched between at least two resistance values ($R_N$, $R_Ü$).

5. Solar module (2) according to Claim 4, in which the resistor (22) contains at least two partial resistances (28) which can be connected as desired between its two terminals (32).

6. Solar module (2) according to one of the preceding claims, having a monitor module (26) monitoring overheating of the converter (6).

7. Solar module (2) according to one of the preceding claims, having a monitor module monitoring an operating period (t) of the transition operation (Ü).

8. Method for operating a solar module (2) according to one of Claims 1 to 7, in which, in a transition operation (Ü) of the solar module (2), the controller (20) drives the semiconductor switch (14) variably in such a way that the latter exhibits a switching behaviour that is slower as compared with normal operation (N), in such a way that a dynamic overvoltage on the semiconductor switch (14) is reduced such that the voltage present on the semiconductor switch (14) does not exceed the blocking voltage of the semiconductor switch (14), wherein, as a result of the slower switching behaviour, the changes over time in the currents (I) in the converter (6) are lower than in normal operation (N), wherein the transition operation (Ü) is then always carried out when the DC voltage (U) is greater than a maximum voltage ($U_{max}$).

9. Method according to Claim 8, in which the value ($U_{Ü,N}$) of the voltage ($U_G$) fed to the switching input (18) is varied.

10. Method according to Claim 8 or 9, in which the resistance value ($R_{Ü,N}$) of the electrical resistor (22) leading to the switching input (18) is varied.

11. Method according to Claim 10, in which a switch is made between at least two resistance values ($R_N$, $R_Ü$) of the resistor (22).

12. Method according to Claim 11, in which at least two partial resistances (28) can be connected as desired between the two terminals (32) of the resistor (22).

13. Method according to one of Claims 8 to 12, in which the monitor module (26) monitors overheating of the converter (6).

14. Method according to one of Claims 8 to 13, in which the monitor module (26) monitors the operating period (t) of the transition operation (Ü).

**Revendications**

1. Module solaire (2) avec une cellule solaire (4) produisant une tension continue (U) et avec un convertisseur de courant (6) convertissant la tension continue (U) introduite à son entrée (8) qui contient au moins un commutateur à semi-conducteurs (14) et une commande (20) pilotant une entrée de commutation (18) du commutateur à semi-conducteurs (14), pour lequel la commande (20) est constituée de telle manière qu'elle commande de façon modifiée au moins un commutateur à semi-conducteurs (14) dans un fonctionnement transitoire (Ü) du module solaire (2) de telle sorte que celui-ci montre un comportement de commutation plus lent par rapport à un fonctionnement normal (N) de telle manière qu'une surtension dynamique sur le commutateur à semi-conducteurs (14) est réduit de telle manière que la tension s'appliquant au commutateur à semi-conducteurs (14) ne dépasse pas la tension de blocage du commutateur à semi-conducteurs (14), les modifications dans le temps des courants (I) par le comportement de commutation plus lent étant plus faibles dans le convertisseur de courant (6) que dans le fonctionnement normal (N), le fonctionnement transitoire (Ü) ayant toujours lieu ensuite si la tension continue (U) est supérieure à une tension maximum ($U_{max}$).

2. Module solaire (2) selon la revendication 1, la commande (20) contenant une source de tension (21) commandant le commutateur à semi-conducteurs (14), pour lequel la valeur de la tension de commutation ($U_G$) acheminée à l'entrée de commutation (18) peut être modifiée.

3. Module solaire (2) selon l'une quelconque des revendications précédentes, la commande (20) présentant une résistance électrique (22) conduisant à l'entrée de commutation (18), pour lequel la valeur de résistance ($R_{Ü,N}$) de la résistance (22) peut être modifiée.

4. Module solaire (2) selon la revendication 3, pour lequel la résistance (22) est une résistance réversible entre au moins deux valeurs de résistance ($R_N$, $R_Ü$).

**5.** Module solaire (2) selon la revendication 4, pour lequel la résistance (22) contient entre ses deux connexions (32) au minimum deux résistances partielles (28) commutables sélectivement.

**6.** Module solaire (2) selon l'une quelconque des revendications précédentes avec un module de contrôle (26) surveillant une surchauffe du convertisseur de courant (6).

**7.** Module solaire (2) selon l'une quelconque des revendications précédentes avec un module de contrôle surveillant une durée de fonctionnement (t) du fonctionnement transitoire (Ü).

**8.** Procédé destiné à faire fonctionner un module solaire (2) selon l'une quelconque des revendications 1 à 7, pour lequel la commande (20) dans un fonctionnement transitoire (Ü) du module solaire (2) commande de façon modifiée le commutateur à semi-conducteurs (14) de telle sorte que celui-ci montre un comportement de commutation plus lent par rapport à un fonctionnement normal (N) de telle manière qu'une surtension dynamique sur le commutateur à semi-conducteurs (14) est réduite de telle manière que la tension s'appliquant au commutateur à semi-conducteurs (14) ne dépasse pas la tension de blocage du commutateur à semi-conducteurs (14), les modifications dans le temps des courants (I) par le comportement de commutation plus lent étant plus faibles dans le convertisseur de courant (6) que dans le fonctionnement normal (N), le fonctionnement transitoire (Ü) ayant toujours lieu ensuite si la tension continue (U) est supérieure à une tension maximum ($U_{max}$).

**9.** Procédé selon la revendication 8, pour lequel la valeur ($U_{Ü,N}$) de la tension ($U_G$) acheminée à l'entrée de commutation (18) est modifiée.

**10.** Procédé selon la revendication 8 ou 9, pour lequel la valeur de résistance ($R_{Ü,N}$) de la résistance électrique (22) conduisant à l'entrée de commutation (18) est modifiée.

**11.** Procédé selon la revendication 10, pour lequel une inversion de commutation a lieu entre au moins deux valeurs de résistance ($R_N$, $R_Ü$) de la résistance (22).

**12.** Procédé selon la revendication 11, pour lequel au moins deux résistances partielles (28) sont enclenchées sélectivement entre les deux connexions (32) de la résistance (22).

**13.** Procédé selon l'une quelconque des revendications 8 à 12, pour lequel le module de contrôle (26) surveille une surchauffe du convertisseur de courant (6).

**14.** Procédé selon l'une quelconque des revendications 8 à 13, pour lequel le module de contrôle (26) surveille la durée de fonctionnement (t) du fonctionnement transitoire (Ü).

Fig. 1

Fig. 2

$R_N$  28

80

N

32

$R_\ddot{U}$

32  $\ddot{U}$

22

EP 2 533 294 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2001103791 A
- KR 1020090096781 A
- JP 11234104 A